# EUROPEAN PATENT APPLICATION

(11) **EP 4 783 763 A1**
(43) Date of publication of application: **29.07.2026**
(21) Application number: 24891711.4
(22) Date of filing: 07.11.2024
(51) Int. Cl.: H05K 7/20, H05K 9/00, H01L 23/373, H01L 23/427, C09K 5/06

(54) **ELECTRONIC DEVICE COMPRISING HEAT DISSIPATION MEMBER**

(30) Priority: 14.11.2023 KR 20230157609; 29.12.2023 KR 20230196575
(71) Applicant: Samsung Electronics Co., Ltd., Suwon-si, Gyeonggi-do 16677 (KR)
(72) Inventor: KIM, Boram, Suwon-si Gyeonggi-do 16677 (KR); KWON, Ohhyuck, Suwon-si Gyeonggi-do 16677 (KR); KIM, Youngjin, Suwon-si Gyeonggi-do 16677 (KR); PARK, Min, Suwon-si Gyeonggi-do 16677 (KR); SUNG, Jungoh, Suwon-si Gyeonggi-do 16677 (KR); SON, Changjong, Suwon-si Gyeonggi-do 16677 (KR); CHANG, Yoonhee, Suwon-si Gyeonggi-do 16677 (KR); JUNG, Jinhwan, Suwon-si Gyeonggi-do 16677 (KR); HWANG, Jieun, Suwon-si Gyeonggi-do 16677 (KR); SON, Jihyeon, Suwon-si Gyeonggi-do 16677 (KR); YOON, Jeonggen, Suwon-si Gyeonggi-do 16677 (KR)
(74) Representative: Gulde & Partner
(86) International application number: PCT/KR2024/017524
(87) International publication number: WO 2025/105765

(57) **Abstract**

The present disclosure relates to an electronic device. An electronic device according to an embodiment of the present disclosure may include: a printed circuit board; a first electronic component mounted on the printed circuit board; a second electronic component arranged on a first region of the surface of the first electronic component; and a thermal reactive heat dissipation member which includes a heat dissipation material and is in contact with a second region of the surface of the first electronic component and the top surface of the second electronic component, wherein the heat dissipation member may be configured to be in a solid phase and may be configured to soften on the basis of the temperature of the heat dissipation member.

## Description

### [Technical Field]

The disclosure relates to electronic devices, e.g., to electronic devices including a heat dissipation structure for electronic components.

### [Background Art]

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images.

As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

### [Disclosure of Invention]

### [Solution to Problems]

An electronic device according to an embodiment of the disclosure may comprise a printed circuit board, a first electronic component mounted on the printed circuit board, a second electronic component mounted in a first area of a surface of the first electronic component, and a thermoresponsive heat dissipation member comprising a heat dissipating material and contacting a second area of the surface of the first electronic component and a top surface of the second electronic component, wherein the heat dissipation member is configured to be in a solid phase and is configured to be softened based on a temperature of the heat dissipation member.

An electronic device according to an embodiment of the disclosure may comprise: a printed circuit board, a first electronic component disposed on the printed circuit board, a second electronic component disposed on a first surface of the first electronic component, a heat dissipation member comprising a heat dissipating material disposed on a first surface of the second electronic component, a first conductive sheet stacked on a first surface of the heat dissipation member, a shield can disposed on the printed circuit board, surrounding the first electronic component and the second electronic component, and including a first opening where the heat dissipation member is accommodated, and a second conductive sheet disposed between the shield can and the first conductive sheet, including a second opening where the heat dissipation member is accommodated, and having a lower thermal conductivity than the first conductive sheet.

### [Brief Description of Drawings]

FIG. 1 is a block diagram illustrating an electronic device in a network environment according to an embodiment;
FIG. 2 is a front exploded perspective view illustrating an electronic device according to an embodiment of the disclosure;
FIG. 3 is a cross-sectional view illustrating a portion of an electronic device according to an embodiment of the disclosure, taken along line A-A' of FIG. 2, illustrating a substrate assembly;
FIG. 4 is an exploded cross-sectional view illustrating a substrate assembly according to an embodiment of the disclosure as illustrated in FIG. 3;
FIG. 5 is a graph illustrating a phase change according to a temperature of a phase change material included in a heat dissipation member according to an embodiment of the disclosure;
FIG. 6 illustrates an electronic component and a solid heat dissipation member disposed on the electronic component as viewed in two directions according to an embodiment of the disclosure;
FIG. 7 illustrates a gel-phase heat dissipation member compressed by a conductive layer and an electronic component as viewed in two directions according to an embodiment of the disclosure;
FIG. 8 is a view illustrating a process for manufacturing a heat dissipation member according to an embodiment of the disclosure;
FIG. 9 illustrates a heat dissipation member and a conductive layer according to an embodiment of the disclosure;
FIG. 10 is a perspective view illustrating a heat dissipation member having a slot according to an embodiment of the disclosure;
FIG. 11 is a cross-sectional view illustrating an area where a slot of a heat dissipation member is formed according to an embodiment of the disclosure;
FIG. 12 is a cross-sectional view illustrating an area where a slot of a heat dissipation member is formed according to an embodiment of the disclosure;
FIG. 13 is a cross-sectional view illustrating an area where a slot of a heat dissipation member is formed according to an embodiment of the disclosure;
FIG. 14 is a perspective view illustrating a heat dissipation member having a slot according to an embodiment of the disclosure;
FIG. 15 is a perspective view illustrating a heat dissipation member having a slot according to an embodiment of the disclosure;
FIG. 16 is a perspective view illustrating a heat dissipation member according to an embodiment of the disclosure;
FIG. 17 is a perspective view illustrating a heat dissipation member according to an embodiment of the disclosure;
FIG. 18 illustrates an electronic component and the heat dissipation member of FIG. 17 disposed on the electronic component as viewed in two directions according to an embodiment of the disclosure;
FIG. 19 is a perspective view illustrating a heat dissipation member according to an embodiment of the disclosure;
FIG. 20 illustrates the heat dissipation member and electronic components of FIG. 19 according to an embodiment of the disclosure;
FIG. 21 is a cross-sectional view illustrating a conductive layer according to an embodiment of the disclosure;
FIG. 22 is a cross-sectional view illustrating a portion of an electronic device according to an embodiment of the disclosure, illustrating a substrate assembly; and
FIG. 23 is a cross-sectional view illustrating the conductive layer of FIG. 22 according to an embodiment of the disclosure.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

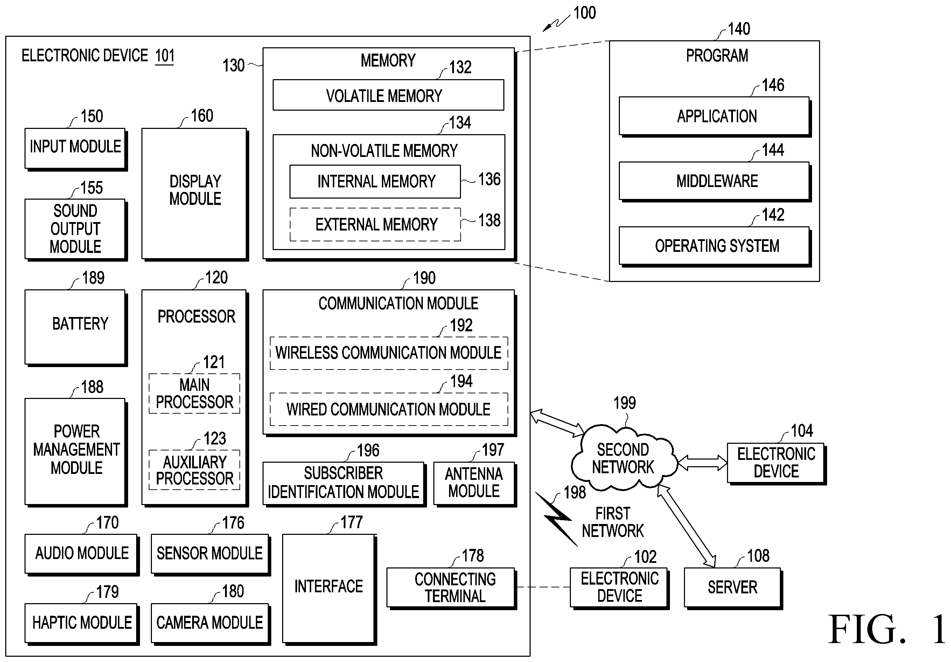

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

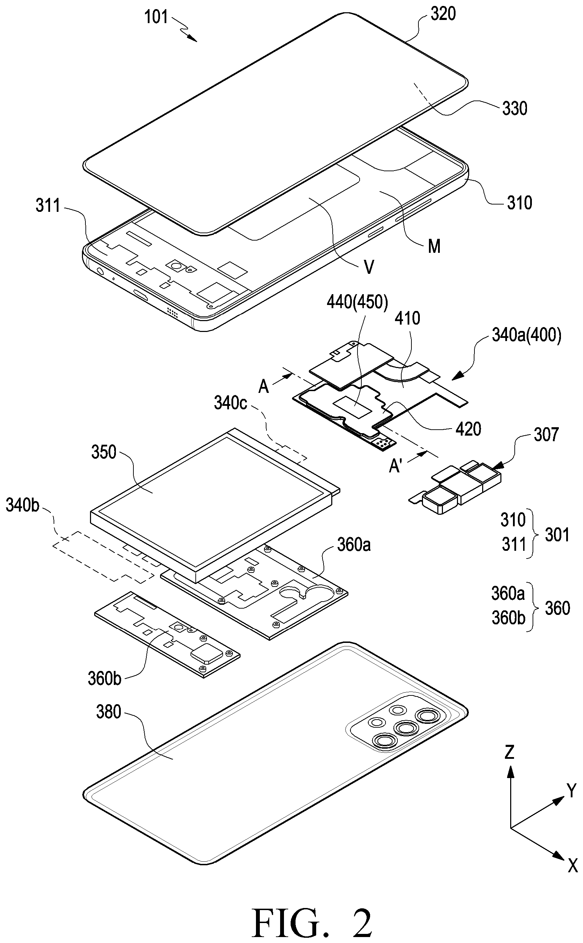

FIG. 2 is a front exploded perspective view illustrating an electronic device 101 according to an embodiment of the disclosure.

Referring to FIG. 2, an electronic device 101 (e.g., the electronic device 101 of FIG. 1) according to an embodiment of the disclosure may include a side structure 310, a first supporting member 311 (e.g., a bracket), a front plate 320, a display 330, at least one printed circuit board (or substrate assembly) 340a or 340b, a battery 350, a second supporting member 360 (e.g., a rear case), an antenna, a camera assembly 307, and a rear plate 380. When the plurality of printed circuit boards 340a and 340b are included, the electronic device 101 may include at least one flexible printed circuit board 340c to electrically connect different printed circuit boards. For example, the printed circuit boards 340a and 340b may include a first circuit board 340a disposed above the battery 350 and a second circuit board 340b disposed under the battery 350, and the flexible circuit board 340c may electrically connect the first circuit board 340a and the second circuit board 340b.

According to an embodiment of the disclosure, the electronic device 101 may exclude at least one (e.g., the first supporting member 311 or the second supporting member 360) of the components or may add other components. At least one of the components of the electronic device 101 may be the same or similar to at least one of the components of the electronic device 101 of FIG. 1 and no duplicate description is made below.

According to an embodiment of the disclosure, at least a portion of the first supporting member 311 may be provided in a flat plate shape. In an embodiment, the first supporting member 311 may be disposed inside the electronic device 101 to be connected with the side structure 310 or integrated with the side structure 310. The first supporting member 311 may be formed of, e.g., a metallic material and/or non-metallic material (e.g., polymer). When the first supporting member 311 is at least partially formed of a metallic material, a portion of the side structure 310 or the first supporting member 311 may function as an antenna. The display 330 may be joined onto one surface of the first supporting member 311, and the printed circuit boards 340a and 340b may be joined onto the opposite surface of the first supporting member 311. A processor, a processor, memory, and/or interface may be mounted on the printed circuit boards 340a and 340b. The processor may include one or more of, e.g., a central processing unit, an application processor, a graphic processing device, an image signal processing, a sensor hub processor, or a communication processor. The processor may be the same as or similar to the processor 120 described above with reference to FIG. 1.

According to an embodiment of the disclosure, the front plate 320 may be coupled to the supporting member 311 through an adhesive member. The front cover may be referred to as a "cover" or "front cover." The rear plate 380 may be referred to as a "cover" or "rear cover." The edge of the cover 380 may be supported by the supporting member 311.

According to an embodiment of the disclosure, the first supporting member 311 and the side structure 310 may be collectively referred to as a front case or a housing 301. The housing 301 may also be referred to as a frame 301. According to an embodiment, the housing 301 may be generally understood as a structure for receiving, protecting, or disposing the printed circuit boards 340a and 340b or the battery 350.

In an embodiment of the disclosure, the housing 301 may be understood as including a structure that the user may visually or tactfully recognize from the exterior of the electronic device 101, e.g., the side structure 310, the front plate 320, and/or the rear plate 380. The housing 301 may include a side structure 310, a first supporting member 311, a front plate 320, and a rear plate 380. In an embodiment of the disclosure, the 'front surface or rear surface of the housing 301' may refer to the front plate 320 or the rear cover 380. In an embodiment, the first supporting member 311 may be disposed between the front plate 320 and the rear plate 380 and may function as a structure for placing an electrical/electronic component, such as the printed circuit boards 340a and 340b or the camera assembly 307.

In an embodiment of the disclosure, the memory (e.g., the memory 130 of FIG. 1) may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment of the disclosure, the second supporting member 360 may include, e.g., an upper supporting member 360a and a lower supporting member 360b. In an embodiment, the upper supporting member 360a, together with a portion of the first supporting member 311, may be disposed to surround the printed circuit boards 340a and 340b (e.g., the first circuit board 340a). For example, the upper supporting member 360a of the second supporting member 360 may be disposed to face the first supporting member 311 with the first circuit board 340a interposed therebetween.

In an embodiment of the disclosure, the lower supporting member 360b of the second supporting member 360 may be disposed to face the first supporting member 311 with the second circuit board 340b interposed therebetween. A circuit device (e.g., a processor, a communication module, or a memory) implemented in the form of an integrated circuit chip or various electrical/electronic components may be disposed on the printed circuit boards 340a and 340b. According to an embodiment, the printed circuit boards 340a and 340b may receive an electromagnetic shielding environment from the second supporting member 360. In an embodiment, the lower supporting member 360b may be utilized as a structure in which electrical/electronic components, such as a speaker module and an interface (e.g., a USB connector, an SD card/MMC connector, or an audio connector) may be disposed.

In an embodiment of the disclosure, electrical/electronic components, such as a speaker module and an interface (e.g., a USB connector, an SD card/MMC connector, or an audio connector) may be disposed on an additional printed circuit board (not shown). For example, the lower supporting member 360b, together with the other part of the first supporting member 311, may be disposed to surround the additional printed circuit board.

The battery 350 may be a device for supplying power to at least one component of the electronic device 101. The battery 189 may include, e.g., a primary cell which is not rechargeable, a secondary cell which is rechargeable, or a fuel cell. At least a portion of the battery 350 may be disposed on substantially the same plane as the printed circuit boards 340a and 340b. The battery 350 may be integrally or detachably disposed inside the electronic device 101.

Although not shown, the antenna may include a conductor pattern implemented on the surface of the second supporting member 360 through, e.g., laser direct structuring. In an embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the disclosure, another antenna structure may be formed by a portion or combination of the side structure 310 and/or the first supporting member 311.

According to an embodiment of the disclosure, the electronic device 101 may include a metal cover M. As an example, the housing 301 may include a metal cover M covering the conductive layer 440 or the coating layer 450. According to an embodiment of the disclosure, the electronic device 101 may include a vapor chamber (V) for dissipating heat to the outside. The vapor chamber V may be disposed on the metal cover M. Accordingly, heat generated from the substrate assembly 400 may be discharged to the outside through the metal cover M and the vapor chamber V.

Referring to FIG. 2, the electronic device 101 according to an embodiment of the disclosure may include a substrate assembly 400. The substrate assembly 400 may include a printed circuit board and a plurality of electronic components (e.g., a processor, a memory, an interposer, etc.) mounted on the printed circuit board. The description of the substrate assembly 340a made with reference to FIG. 2 may be equally applied to the substrate assembly 400.

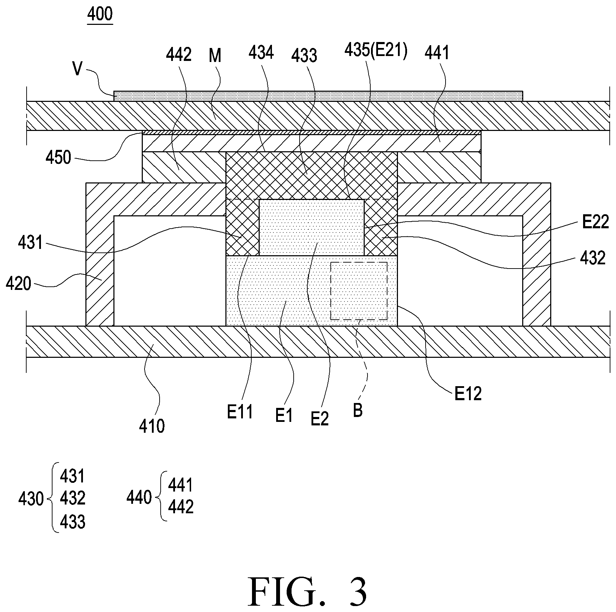

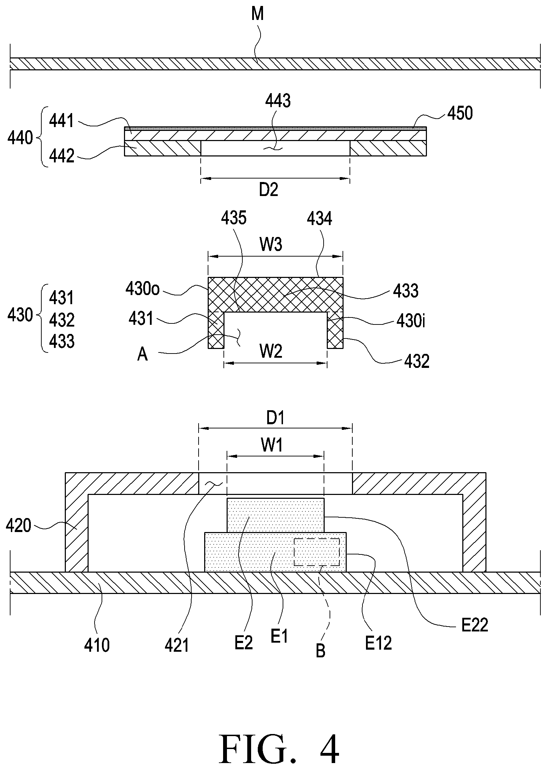

According to an embodiment of the disclosure, the substrate assembly 400 may include a printed circuit board 410, a shield can 420, a heat dissipation member 430 (see FIG. 3), a conductive layer 440, and/or a coating layer 450. The substrate assembly 400 is described below in detail with reference to FIGS. 3 and 4.

FIG. 3 is a cross-sectional view illustrating a portion of an electronic device 101 according to an embodiment of the disclosure, taken along line A-A' of FIG. 2, illustrating a substrate assembly 400.

Referring to FIG. 3, a substrate assembly 400 according to an embodiment of the disclosure may include a printed circuit board 410. At least one electronic component E1 or E2 may be disposed on the printed circuit board 410.

According to an embodiment of the disclosure, the substrate assembly 400 may include a first electronic component E1 mounted on the printed circuit board 410. The first electronic component E1 may perform one function of the electronic device 101. As an example, the first electronic component E1 may include a processor (e.g., the processor 120 of FIG. 1). The first electronic component E1 may be connected to an external power source (e.g., the battery 350 of FIG. 2).

According to an embodiment of the disclosure, the first electronic component E1 may include a hot block B. The hot block B may be a portion having a relatively large heat generation amount in the first electronic component E1. As an example, the first electronic component E1 may include a processor (e.g., the processor 120 of FIG. 1), and the hot block B may include at least one processing core as a CPU/GPU part. As another example, the hot block B may include any one of a plurality of processing cores or a plurality of cores adjacent to each other.

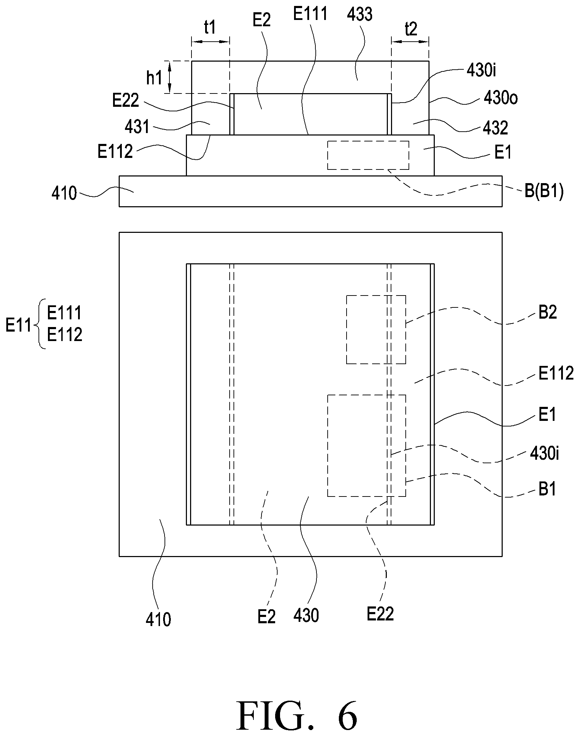

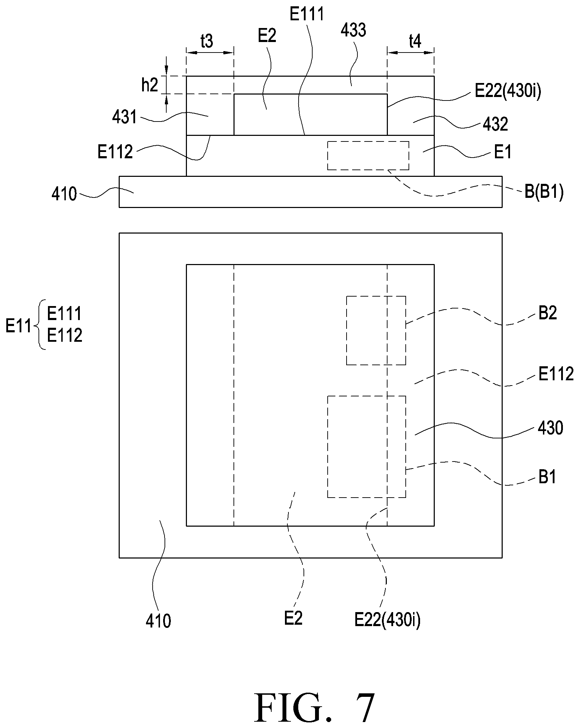

According to an embodiment of the disclosure, the hot block B may be positioned at an edge of the first electronic component E1 to be connected to a power source (e.g., the battery 350 of FIG. 2). The hot block B may at least partially overlap the second area E112 (see, e.g., FIG. 6 or 7) of the surfaces E11 and E12 of the first electronic component E1. As an example, as illustrated in FIG. 3, the hot block B may overlap an edge of the second electronic component E2 in a direction in which the first electronic component E1 and the second electronic component E2 are stacked. As another example, unlike that illustrated in FIG. 3, the hot block B may be positioned outside the edge of the second electronic component E2, and thus may not overlap the edge of the second electronic component E2 in the direction in which the first electronic component E1 and the second electronic component E2 are stacked.

According to an embodiment of the disclosure, the substrate assembly 400 may include a second electronic component E2 disposed on the first electronic component E1. The second electronic component E2 may be mounted on the first surface E11 of the first electronic component E1. As an example, the first surface E11 of the first electronic component E1 may be a top surface of the first electronic component E1. As an example, the second electronic component E2 may be disposed on the first surface E11 of the first electronic component E1, and the printed circuit board 410, the first electronic component E1, and the second electronic component E2 may be stacked in a line (aligned).

According to an embodiment of the disclosure, the second electronic component E2 may be disposed on a portion of the first surface E11 of the first electronic component E1. As an example, the second electronic component E2 may be disposed on a center portion of the first electronic component E1. The remaining portion of the first surface E11 of the first electronic component E1 where the second electronic component E2 is not disposed may contact the heat dissipation member 430.

According to an embodiment of the disclosure, the second electronic component E2 may be electrically connected to the first electronic component E1. The second electronic component E2 may be operatively connected to the first electronic component E1. As an example, the first electronic component E1 may include a processor (e.g., the processor 120 of FIG. 1), and the second electronic component E2 may be memory (e.g., the memory 130 of FIG. 1) mounted on the first surface E11 of the first electronic component E1 through a solder ball.

For example, the first electronic component E1 may be a processor (e.g., the processor 120 of FIG. 1) including at least one processing core, and the second electronic component E2 may be memory (e.g., the memory 130 of FIG. 1) operatively connected to the at least one processing core and storing instructions performed by the at least one processing core.

According to an embodiment of the disclosure, the substrate assembly 400 may include a heat dissipation member 430. The heat dissipation member 430 may comprise a heat dissipation material. The heat dissipation member 430 may contact the first electronic component E1 and the second electronic component E2. The heat generated from the first electronic component E1 and the second electronic component E2 may be discharged to the outside of the substrate assembly 400 by the heat dissipation member 430.

According to an embodiment of the disclosure, the heat dissipation member 430 may include a first portion 433 contacting a first surface E21 of the second electronic component E2. The first portion 433 of the heat dissipation member 430 may be disposed between the second electronic component E2 and the first conductive sheet 441. Accordingly, heat of the second electronic component E2 may be diffused to the first conductive sheet 441 through the first portion 433. Further, heat of the first electronic component E1 may be diffused to the first conductive sheet 441 through the second electronic component E2 and the first portion 433.

According to an embodiment of the disclosure, the heat dissipation member 430 may include second portions 431 and 432 contacting the first surface E11 of the first electronic component E1. Accordingly, heat of the first electronic component E1 may be diffused from the first surface E11 to the second portions 431 and 432 of the heat dissipation member 430.

According to an embodiment of the disclosure, the second portions 431 and 432 of the heat dissipation member 430 may be adjacent to the hot block B of the first electronic component E1. The second portions 431 and 432 of the heat dissipation member 430 may overlap the heat dissipation block B in the stacked direction of the second electronic component E2 and the first portion 433 of the heat dissipation member 430. Accordingly, heat of the hot block B of the first electronic component E1 may be diffused to the second portions 431 and 432 of the heat dissipation member 430.

According to an embodiment of the disclosure, the second portions 431 and 432 of the heat dissipation member 430 may extend from the first portion 433 toward the first surface E11 of the first electronic component E1. As an example, the second portions 431 and 432 may protrude from an edge of the first portion 433 toward the first surface E11 of the first electronic component E1.

According to an embodiment of the disclosure, the heat dissipation member 430 may cover the second electronic component E2. The first portion 433 of the heat dissipation member 430 may cover at least a portion of the first surface E21 of the second electronic component E2. The second portions 431 and 432 of the heat dissipation member 430 may cover at least a portion of the second surface E22 of the second electronic component E2. As an example, the first surface E21 of the second electronic component E2 may be a top surface, and the second surface E22 may be a side surface.

According to an embodiment of the disclosure, the substrate assembly 400 may include a shield can 420 disposed on the printed circuit board 410. The shield can 420 may surround the first electronic component E1 and the second electronic component E2. The shield can 420 may minimize and/or reduce penetration of an external magnetic field into the first electronic component E1 and the second electronic component E2. The shield can 420 may be connected to a ground layer (not shown) through the printed circuit board 410 or may be electrically connected to the printed circuit board 410 to ground a current formed by an external magnetic field to the outside of the substrate assembly 400.

According to an embodiment of the disclosure, the substrate assembly 400 may include a conductive layer 440 disposed on the shield can 420. As an example, the conductive layer 440 may contact the shield can 420 or may be adhered to the shield can 420 by a conductive adhesive. The conductive layer 440 and the shield can 420 may limit a space capable of minimizing/reducing influence by an external magnetic field. The shield can 420 and the conductive layer 440 may surround the first electronic component E1, the second electronic component E2, and the heat dissipation member 430. Accordingly, the influence of the external magnetic field on the first electronic component E1 and the second electronic component E2 may be minimized and/or reduced.

According to an embodiment of the disclosure, the conductive layer 440 may include a first conductive sheet 441 disposed on a first surface 434 (top surface) of the heat dissipation member 430. The first conductive sheet 441 may cover the first surface 434 of the heat dissipation member 430. For example, the first conductive sheet 441 may contact the first surface 434 of the heat dissipation member 430. Accordingly, heat may be diffused from the heat dissipation member 430 to the first conductive sheet 441. As an example, the first conductive sheet 441 may be a copper thin film.

According to an embodiment of the disclosure, the substrate assembly 400 may include a metal cover M. The metal cover M may reinforce the rigidity of the substrate assembly 400. The metal cover M may be stacked on the first conductive sheet 441. Accordingly, heat may be diffused from the first conductive sheet 441 to the metal cover M.

According to an embodiment of the disclosure, the coating layer 450 may be disposed between the first conductive sheet 441 and the metal cover M. As an example, the coating layer 450 may be coated on one surface of the first conductive sheet 441 facing the metal cover M. The coating layer 450 may include a heat dissipation material. Heat may be diffused from the first conductive sheet 441 to the metal cover M through the coating layer 450.

According to an embodiment of the disclosure, the conductive layer 440 may be supported by the shield can 420. The conductive layer 440 may include a second conductive sheet 442 interposed between the first conductive sheet 441 and the shield can 420. The second conductive sheet 442 may surround a portion of the heat dissipation member 430. For example, the second conductive sheet 442 may contact a side surface (e.g., the outer surface 430o of FIG. 4) of the heat dissipation member 430. Accordingly, heat may be diffused from the heat dissipation member 430 to the second conductive sheet 442. As an example, the second conductive sheet 442 may be a metal thin film having lower thermal conductivity than the first conductive sheet 441.

According to an embodiment of the disclosure, the shield can 420 and the first conductive sheet 441 may be electrically connected through the second conductive sheet 442. Accordingly, the first electronic component E1 and the second electronic component E2 may minimize and/or reduce the influence of the external magnetic field through the shield can 420, the second conductive sheet 442, and the first conductive sheet 441.

According to an embodiment of the disclosure, the shield can 420 may include a first opening 421 (see FIG. 4). The heat dissipation member 430 may be at least partially positioned inside the first opening 421. The shield can 420 may surround at least a portion of a side surface 430o of the heat dissipation member 430. The shield can 420 may contact the side surface 430o of the heat dissipation member 430. Accordingly, heat may be diffused from the heat dissipation member 430 to the shield can 420.

According to an embodiment of the disclosure, the second conductive sheet 442 may include a second opening 443 (see FIG. 4) in which the heat dissipation member 430 is accommodated. At least a portion of the heat dissipation member 430 may be positioned inside the second opening 443. The second conductive sheet 442 may surround at least a portion of the side surface 430o of the heat dissipation member 430. The second conductive sheet 442 may contact the side surface 430o of the heat dissipation member 430. Accordingly, heat may be diffused from the heat dissipation member 430 to the shield can 420.

FIG. 4 is an exploded cross-sectional view illustrating a substrate assembly 400 according to an embodiment of the disclosure as illustrated in FIG. 3.

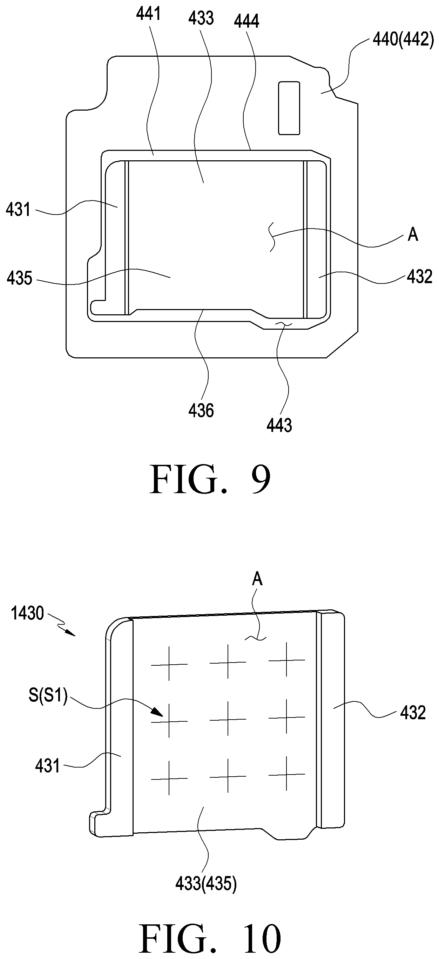

Referring to FIG. 4, the substrate assembly 400 according to an embodiment of the disclosure may be a structure in which the first electronic component E1, the second electronic component E2, the heat dissipation member 430, the conductive layer 440, and the metal cover M are sequentially stacked. The substrate assembly 400 may be manufactured by sequentially stacking (or assembling) the first electronic component E1, the second electronic component E2, the heat dissipation member 430, the conductive layer 440, and the metal cover M, or by integrally assembling adjacent components (e.g., the heat dissipation member 430 and the conductive layer 440) to another component (e.g., the second electronic component E2) (see FIG. 9).

According to an embodiment of the disclosure, the width W3 of the heat dissipation member 430 may be defined by the outer side surface 430o of the heat dissipation member 430. The outer side surface 430o of the heat dissipation member 430 may be referred to as an outer side surface 430o of the heat dissipation member 430. The first opening 421 of the shield can 420 may have a predetermined diameter D1. The width W3 of the heat dissipation member 430 may be smaller than the diameter D1 of the first opening 421 of the shield can 420. Accordingly, the heat dissipation member 430 may be easily inserted into the shield can 420 through the first opening 421 of the shield can 420.

According to an embodiment of the disclosure, the width W1 of the second electronic component E2 may be defined by the second surface E22 of the second electronic component E2. The width W1 of the second electronic component E2 may be smaller than the diameter D1 of the first opening 421 of the shield can 420.

According to an embodiment of the disclosure, the second portions 431 and 432 of the heat dissipation member 430 and the second surface 435 of the first portion 433 of the heat dissipation member 430 may form an accommodation space A in which the second electronic component E2 is accommodated. The distance between the second portions 431 and 432 of the heat dissipation member 430 may be defined as the width W2 of the accommodation space A. The width W2 of the accommodation space A may be referred to as a distance W2 between the second portions 431 and 432 of the heat dissipation member 430. The width W2 of the accommodation space A may be referred to as a distance W2 between the inner surfaces 430i of the second portions 431 and 432 of the heat dissipation member 430.

According to an embodiment of the disclosure, the width W1 of the second electronic component E2 may be smaller than the distance W2 between the second portions 431 and 432 of the heat dissipation member 430. Accordingly, the second electronic component E2 may be easily inserted into the accommodation space A of the heat dissipation member 430, and the heat dissipation member 430 may be easily positioned at the second electronic component E2.

According to an embodiment of the disclosure, the second opening 443 of the second conductive sheet 442 may have a predetermined diameter D2. The width W3 of the heat dissipation member 430 may be smaller than the diameter D2 of the second opening 443 of the second conductive sheet 442. Accordingly, a portion of the heat dissipation member 430 may be easily inserted into the second opening 443 of the second conductive sheet 442, and the conductive layer 440 may be easily positioned on the heat dissipation member 430.

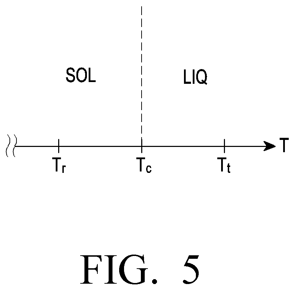

FIG. 5 is a graph illustrating a phase change according to a temperature of a phase change material included in the heat dissipation member 430 according to an embodiment of the disclosure.

According to an embodiment of the disclosure, the heat dissipation member 430 may exhibit thermoresponsive behavior, allowing its physical properties, such as phase or thermal conductivity, to alter in response to temperature of the heat dissipation member 430. For instance, at room temperature, the heat dissipation member 430 may remain in a solid phase, but when the heat dissipation member 430 is heated by absorbing ambient heat, the heat dissipation member 430 transitions into a gel phase. Transition of the phase enhances heat dissipation efficiency of the heat dissipation member 430. The heat dissipation member 430 may comprise a heat dissipation material, phase change material (PCM), and a matrix material. Further details regarding materials included in the heat dissipation member 430 are provided below.

Referring to FIG. 5, the phase change material may be in a solid phase at a temperature lower than the phase change temperature Tc, and may be in a liquid phase or a gel phase at a temperature higher than the phase change temperature Tc. The phase change temperature Tc may be referred to as a threshold temperature. As an example, the phase change material may include a paraffin based material that is a temperature-sensitive material, and the phase change temperature Tc may be a temperature of 45 degrees Celsius to 65 degrees Celsius. The phase change material may be a thermoresponsive material by temperature, and may be, e.g., a thermoplastic polymer.

According to an embodiment of the disclosure, the phase change material may be in a solid phase at room temperature Tr. The heat dissipation member 430 may be in a solid phase at room temperature Tr. As an example, the room temperature Tr may be a temperature of 15 degrees Celsius to 25 degrees Celsius.

According to an embodiment of the disclosure, when the heat dissipation member 430 is in a solid phase, it may be easier to transport, arrange, and assemble the heat dissipation member 430 than when the heat dissipation member 430 is in a liquid phase or gel phase. Further, when the heat dissipation member 430 is in a solid phase, the heat dissipation member 430 maintains a predetermined level of rigidity, and thus defects such as dents on the heat dissipation member 430 that may occur during assembly and transportation may be reduced. Accordingly, it is possible to prevent and/or reduce failure in shape recovery of a dented heat dissipation member 430, and thus minimize and/or reduce deterioration of heat dissipation performance of the heat dissipation member 430.

According to an embodiment of the disclosure, when the heat dissipation member 430 is in a solid phase, a material (e.g., a phase change material) included in the heat dissipation member 430 does not penetrate into the gaps of the shielding structures (e.g., the conductive layer 440 and the shield can 420 of FIG. 3) around the heat dissipation member 430, and thus the shielding performance of the shielding structure may not be impaired. Even if the heat dissipation member 430 becomes the gel phase after the operation of the electronic device 101, the heat dissipation member 430 becomes the gel phase when the phase change temperature Tc is reached after the operation of the electronic device 101, and does not contain silicone resin or oil that causes bleeding, and thus may not impair the shielding performance of the surrounding shielding structures (e.g., the conductive layer 440 and the shield can 420 of FIG. 3).

According to an embodiment of the disclosure, the heat dissipation member 430 may include a matrix material configured to maintain the heat dissipation member 430 in a gel phase at a temperature higher than the phase change temperature Tc. The matrix material may function as a frame of the heat dissipation member 430, thereby substantially maintaining the shape of the heat dissipation member 430 even when the temperature of the heat dissipation member 430 rises to a temperature higher than the phase change temperature Tc. As an example, the matrix material may be a rubber based material. The matrix material is not limited to a rubber based material, and may be replaced with a material capable of functioning as a frame.

According to an embodiment of the disclosure, the heat dissipation member 430 may include heat dissipation particles. As an example, the heat dissipation particles may be aluminum oxide (Al2O3) or aluminum nitride (AlN). As another example, the heat dissipation particles may be carbon fiber, graphene, boron nitride (BN), silicon carbide (SiC), magnesium oxide (MgO), or manganese oxide (ZnO).

According to an embodiment of the disclosure, the heat dissipation member 430 may include heat dissipation particles, a phase change material, and a matrix material. As an example, the heat dissipation member 430 may include about 75 to 90% of heat dissipation particles, about 5 to 15% of matrix material, and about 5 to 15% of phase change material. The composition ratio of the heat dissipation particles, the matrix material, and the phase change material included in the heat dissipation member 430 is not limited to the above examples.

According to an embodiment of the disclosure, as the first electronic component E1 and/or the second electronic component E2 operate, the temperature of the heat dissipation member 430 may increase due to heat generation of the first electronic component E1 and/or the second electronic component E2. When the temperature of the heat dissipation member 430 increases after the first electronic component E1 and/or the second electronic component E2 operates, the heat dissipation member 430 may at least partially change into a gel phase.

According to an embodiment of the disclosure, the phase change temperature Tc may be lower than the throttling temperature Tt of the first electronic component E1. The throttling temperature Tt of the first electronic component E1 may include the throttling temperature of at least one processing unit (e.g., processing core) included in the first electronic component E1. The throttling may be controlling the electronic component so that the amount of heat generated by the electronic component decreases in order to reduce power consumption of the electronic component or prevent and/or reduce failure of the electronic component based on the temperature of the electronic component rises above a specific threshold.

For example, the first electronic component E1 may include a processor (e.g., the processor 120 of FIG. 1), and the processor E1 may include a plurality of processing cores. The throttling temperature Tt of the first electronic component E1 may include throttling temperatures of a plurality of processing cores. The threshold temperature Tc of the first electronic component E1 may be lower than the throttling temperatures of the plurality of processing cores. According to an embodiment of the disclosure, in the operation of the electronic device (e.g., the electronic device 101 of FIG. 2), the temperature of the first electronic component E1 and/or the second electronic component E2 may not increase from the throttling temperature Tt by a predetermined range or more. At the throttling temperature Tt of the first electronic component E1 and/or the second electronic component E2, the phase change material may be in a liquid phase, and the heat dissipation member 430 may be in a gel phase.

FIG. 6 illustrates an electronic component E1 or E2 and a solid heat dissipation member 430 disposed on the electronic component E1 or E2 as viewed in two directions according to an embodiment of the disclosure. FIG. 7 illustrates a gel-phase heat dissipation member 430 compressed by a conductive layer 440 (see FIG. 3) and an electronic component E1 or E2 as viewed in two directions according to an embodiment of the disclosure.

Referring to FIG. 6, according to an embodiment of the disclosure, the first portion 433 of the solid-phase heat dissipation member 430 before being changed to the gel phase may have a first height h1. The plurality of second portions 431 and 432 may have a first thickness t1 and a second thickness t2, respectively. Distances between the inner surface 430i and the outer side surface 430o of the plurality of second portions 431 and 432 may be a first thickness t1 and a second thickness t2, respectively.

According to an embodiment of the disclosure, the inner surfaces 430i of the second portions 431 and 432 of the solid-phase heat dissipation member 430 before being changed to the gel phase may be spaced apart from the second surface E22 of the second electronic component E2 for easy coupling of the heat dissipation member 430. Accordingly, the heat dissipation member 430 may be easily assembled to the second electronic component E2.

Referring to FIG. 7, according to an embodiment of the disclosure, the first portion 433 of the heat dissipation member 430 in the state of being compressed by the conductive layer 440 after being changed to the gel phase may have a second height h2 smaller than the first height h1. The plurality of second portions 431 and 432 of the heat dissipation member 430 compressed by the conductive layer 440, respectively, may have a third thickness t3 larger than the first thickness t1 and a fourth thickness t4 larger than the second thickness t2. The third thickness t3 and the fourth thickness t4 may be the largest thicknesses of the plurality of second portions 431 and 432, respectively.

Referring to FIGS. 6 and 7, the heat dissipation member 430 according to an embodiment of the disclosure may be changed to a gel phase and then compressed by the conductive layer 440. When compressed by the conductive layer 440, the height of the first portion 433 of the heat dissipation member 430 may be reduced from the first height h1 to the second height h2. The difference between the first height h1 and the second height h2 may be due to an assembly tolerance that may occur during manufacturing of the substrate assembly 400. For example, tolerances such as assembly tolerances that may occur in the process of assembling the components 410, 420, 430, 440, E1, and E2 of the substrate assembly 400, and component height tolerances of the printed circuit board 410 and the electronic components E1 and E2 may occur.

According to an embodiment of the disclosure, the heat dissipation member 430 in the gel phase may have a higher compression rate than the heat dissipation member 430 in the solid phase. As an example, the heat dissipation member 430 in the gel phase may have a compression rate of about 25 to 40%, and for example, may have a compression rate of about 35 to 40%. Since the heat dissipation member 430 of the disclosure has a high compression rate in the gel phase compared to a solid phase, the tolerances may be filled by the heat dissipation member 430. As an example, the heat dissipation member 430 may be configured to have a compressibility of about 35 to 40% when the temperature is higher than the threshold temperature Tc and at least partially becomes a gel phase, and the second height h2 may be a value reduced by about 35 to 40% from the first height h1.

According to an embodiment of the disclosure, as the height of the first portion 433 of the heat dissipation member 430 decreases, the thicknesses of the second portions 431 and 432 of the heat dissipation member 430 may increase. As the thickness of the second portions 431 and 432 of the heat dissipation member 430 increases, the second portions 431 and 432 may tightly contact the second surface E22 of the second electronic component E2. As the thickness of the second portions 431 and 432 of the heat dissipation member 430 increases, the inner surface 430i of the second portions 431 and 432 may tightly contact the second surface E22 of the second electronic component E2. As the thickness of the second portions 431 and 432 of the heat dissipation member 430 increases, the second portions 431 and 432 may tightly contact the shield can 420 (see FIG. 3).

According to an embodiment of the disclosure, the first surface E11 of the surfaces E11 and E12 of the first electronic component E1 may include a first area E111 at which the second electronic component E2 is disposed. Heat may be diffused from the first electronic component E1 to the second electronic component E2 through the first area E111.

According to an embodiment of the disclosure, the first surface E11 of the surfaces E11 and E12 of the first electronic component E1 may include a second area E112 in contact with the second portions 431 and 432 of the heat dissipation member 430. The second area E112 may at least partially surround the first area E111. Heat may be diffused from the first electronic component E1 to the second portions 431 and 432 of the heat dissipation member 430 through the second area E112.

Referring to FIGS. 6 and 7, according to an embodiment of the disclosure, the first electronic component E1 may include a hot block B. The hot block B may be positioned below the first surface E11 and may overlap the second area E112. The hot block B may be positioned below a boundary between the first area E111 and the second area E112. Heat generated in the hot block B may be diffused to the second electronic component E2 through the first area E111. Heat generated in the hot block B may be diffused to the second portion 432 of the heat dissipation member 430 through the second area E112.

According to an embodiment of the disclosure, the heating portion B may include a first heating portion B1 and a second heating portion B2. The first heating portion B1 and the second heating portion B2 may be positioned below the first surface E11 and may overlap the second area E112. As an example, the first heating portion B1 may be a CPU of a processor (e.g., the processor 120 of FIG. 1), and the second heating portion B2 may be a GPU of a processor (e.g., the processor 120 of FIG. 1).

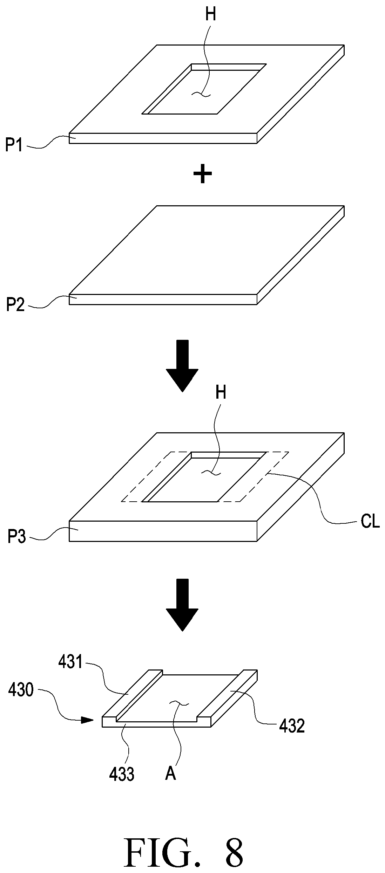

FIG. 8 is a diagram illustrating a process for manufacturing a heat dissipation member 430 according to an embodiment of the disclosure.

Referring to FIG. 8, the heat dissipation member 430 according to an embodiment of the disclosure may be formed by bonding a plurality of (e.g., two) plates P1 and P2. The plates P1 and P2 may be formed of the same material as the heat dissipation member 430 described with reference to FIG. 5. The plates P1 and P2 may be in a solid phase at a temperature lower than the phase change temperature Tc (see FIG. 5) and may be in a gel phase at a temperature higher than the phase change temperature Tc (see FIG. 5).

According to an embodiment of the disclosure, the first plate P1 may include a hole H. The hole H may have a shape corresponding to the second electronic component E2. The second plate P2 may have a shape corresponding to the first surface E21 (see FIG. 3) of the second electronic component E2. The hole H may be an area corresponding to an accommodation space A (see FIG. 4) of the heat dissipation member 430.

According to an embodiment of the disclosure, when the first plate P1 is stacked on the second plate P2 and heat is applied to the first plate P1 and the second plate P2, the first plate P1 and the second plate P2 may be bonded by heat to form a single third plate P3. The first portion 433 and the second portions 431 and 432 of the heat dissipation member 430 may be integrally formed with each other.

According to an embodiment of the disclosure, the first plate P1 and the second plate P2 may be integrally formed without introducing an adhesive member or an adhesive layer. In general, an adhesive member or an adhesive layer may act as an insulating layer. According to an embodiment of the disclosure, the heat dissipation member 430 may include a matrix material and a phase change material to bond the plates P1 and P2 by heat without an adhesive member or an adhesive layer, thereby enhancing the heat dissipation performance of the heat dissipation member 430.

According to an embodiment of the disclosure, when the third plate P3 is punched along a predetermined cutting line CL surrounding the hole H, the heat dissipation member 430 including the first portion 433 and the second portions 431 and 432 may be manufactured.

According to an embodiment of the disclosure, the cutting line CL may at least partially surround the hole H. As an example, as illustrated in FIG. 8, the cutting line CL may partially overlap the hole H or may be partially positioned inside the hole H. The portion between the hole H and a portion of the cutting line CL positioned outside the hole H and the cutting line CL may correspond to the second portions 431 and 432. The shape of the heat dissipation member 430 may vary depending on the shapes of the hole H and the cutting line CL or the number of plates.

According to an embodiment of the disclosure, the first plate P1 and the second plate P2 may be formed of different materials. The compositions of the first plate P1 and the second plate P2 may be different from each other. As an example, the second plate P2 may be conductive by including carbon, and the first plate P1 may be non-conductive by not including carbon. Accordingly, the second portions 431 and 432 of the heat dissipation member 430 may be non-conductive, and the first portion 433 of the heat dissipation member 430 may be conductive. Accordingly, shielding performance may be enhanced through the first portion 433 of the heat dissipation member 430, and the second portions 431 and 432 may be formed to be non-conductive to prevent and/or reduce short circuits of the electronic components E1 and E2.

According to an embodiment of the disclosure, the first plate P1 and the second plate P2 may have different thermal conductivity. As an example, the thermal conductivity of the second portions 431 and 432 of the heat dissipation member 430 may be higher than the thermal conductivity of the first portion 433 of the heat dissipation member 430. Accordingly, heat generated from the first electronic component E1 may be more effectively discharged through the second portions 431 and 432 of the heat dissipation member 430.

According to an embodiment of the disclosure, there may be a plurality of second portions 431 and 432 of the heat dissipation member 430. The plurality of second portions 431 and 432 may be positioned at positions symmetrical to each other with respect to the accommodation area A. The plurality of second portions 431 and 432 may extend along the second surface E22 (see FIG. 5) of the second electronic component E2. As an example, the plurality of second portions 431 and 432 may extend side by side along two side surfaces of the second electronic component E2 facing each other.

FIG. 9 illustrates a heat dissipation member 430 and a conductive layer 440 according to an embodiment of the disclosure.

Referring to FIG. 9, the heat dissipation member 430 according to an embodiment of the disclosure may be attached to the second surface of the first conductive sheet 441. The heat dissipation member 430 may be positioned inside the second opening 443 of the second conductive sheet 442. The heat dissipation member 430 may be partially accommodated in the second opening 443 of the second conductive sheet 442. The edge 436 of the heat dissipation member 430 may be spaced apart from the edge 444 of the second opening 443 of the second conductive sheet 442.

According to an embodiment of the disclosure, the heat dissipation member 430 may be attached to the conductive layer 440 and may be integrally positioned in the second electronic component E2 (see FIG. 4). Since the edge 436 of the heat dissipation member 430 is spaced inward from the edge 444 of the second opening 443 of the second conductive sheet 442, a mis-assembly problem such as the conductive layer 440 being mounted on the heat dissipation member 430 may be prevented/reduced.

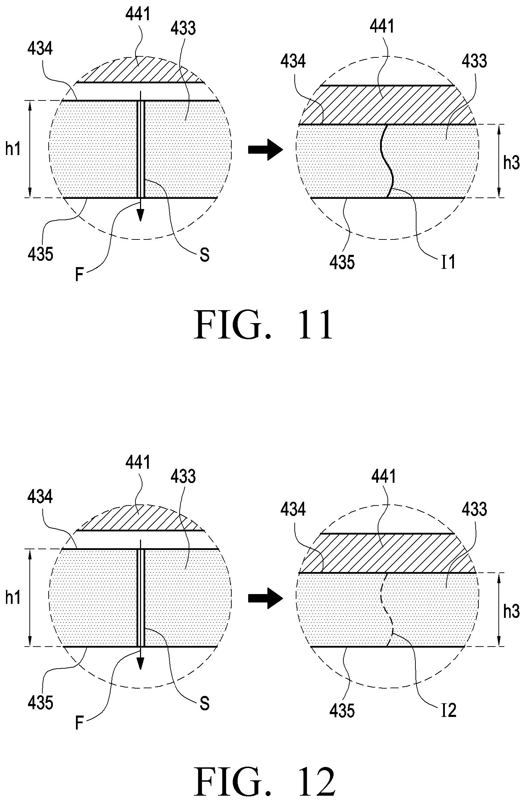

FIG. 10 is a perspective view illustrating a heat dissipation member 1430 having a slot S or S1 according to an embodiment of the disclosure. FIG. 11 is a cross-sectional view illustrating an area where a slot S of a heat dissipation member 1430 is formed according to an embodiment of the disclosure.

The description of the heat dissipation member 430 made with reference to FIGS. 3 to 9 may be equally applied to the heat dissipation member 1430 of the same name described with reference to FIGS. 10 and 11 unless contradictory.

Referring to FIGS. 10 and 11, the heat dissipation member 1430 according to an embodiment of the disclosure may include at least one elongated slot S1. The slot S1 may be formed at the first portion 433 of the heat dissipation member 1430. The slot S1 may pass through the first portion 433 of the heat dissipation member 1430. The slot S1 may be connected from the second surface 435 of the first portion 433 of the heat dissipation member 1430 to the first surface 434.

According to an embodiment of the disclosure, when the heat dissipation member 430 is attached to the first conductive sheet 441, the air F between the heat dissipation member 430 and the first conductive sheet 441 may easily flow to the outside through the slot S1. When air remains between the heat dissipation member 430 and the second surface of the first conductive sheet 441, air bubbles may be formed between the heat dissipation member 430 and the first conductive sheet 441, thereby impairing the heat dissipation performance of the electronic components E1 and E2. Accordingly, by the slots S and S1 according to an embodiment of the disclosure, the first conductive sheet 441 and the heat dissipation member 430 may tightly contact each other, and heat may be diffused from the heat dissipation member 430 to the first conductive sheet 441.

According to an embodiment of the disclosure, the slot S1 may have a cross shape in which two slots cross each other, but the shape of the slot S1 is not limited to the cross shape. A plurality of slots S1 may be provided. A plurality of slots S1 may be positioned at the first portion 433 of the heat dissipation member 1430. As an example, a plurality of slots S1 may be arranged at regular intervals.

According to an embodiment of the disclosure, when the heat dissipation member 1430 is changed into a gel phase and compressed by the conductive layer 440 (see FIG. 7), the height h1 of the first portion 433 of the heat dissipation member 1430 may be reduced to the third height h3. When the heat dissipation member 1430 is changed into the gel phase and compressed by the conductive layer 440, the inner space of the slot S may be filled by the heat dissipation member 1430 in the gel phase. When the heat dissipation member 1430 is changed into a gel phase and compressed by the conductive layer 440, the slot S may not be visually exposed to the outside. When the heat dissipation member 1430 in the gel phase is compressed, the slot S of the heat dissipation member 1430 does not completely disappear, and as illustrated in FIG. 11, it may remain inside the first portion 433 of the heat dissipation member 1430 in the form of an interface.

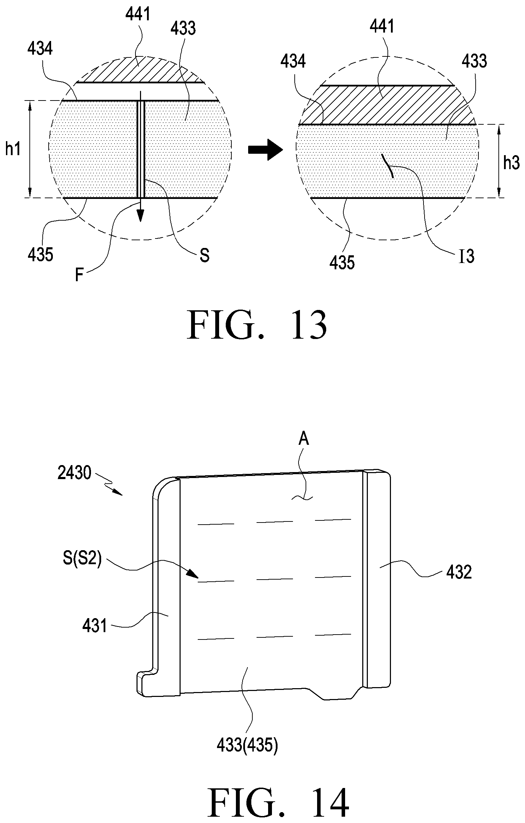

FIG. 12 is a cross-sectional view illustrating an area where a slot S of a heat dissipation member 1430 is formed according to an embodiment of the disclosure. FIG. 13 is a cross-sectional view illustrating an area where a slot S of a heat dissipation member 1430 is formed according to an embodiment of the disclosure.

Referring to FIGS. 11 to 13, the heat dissipation member 1430 according to an embodiment of the disclosure may include at least one interface portion I1, I2, and I3. The interface portions I1, I2, and I3 may be surfaces in which two areas of the first portion 433 positioned on two opposite sides of the slot S contact each other. Some of the plurality of slots S and S1 may not remain as the interface portions I1, I2, and I3, and others may remain as the interface portions I1, I2, and I3.

According to an embodiment, at least one of the plurality of slots S, S1, S2, and S3 may remain inside the first portion 433 in any one of the various forms of interface portions I1, I2, and I3 illustrated in FIGS. 11 to 13. However, the forms of the interface portions I1, I2, and I3 are not limited to the forms illustrated in FIGS. 11 to 13, and may remain in various forms.

According to an embodiment of the disclosure, the interface portions I1, I2, and I3 may be positioned at positions of the slots S and S1. The interfacial portions I1, I2, and I3 may be positioned at the first portion 433 of the heat dissipation member 1430. As an example, the interface portions I1, I2, and I3 may be arranged at predetermined intervals at positions corresponding to the plurality of slots S and S1.

Referring to FIG. 11, according to an embodiment, the first interface portion I1 may be configured to connect the second surface 435 and the first surface 434 of the first portion 433 of the heat dissipation member 1430. The first interface portion I1 may extend curvedly between the second surface 435 of the first portion 433 and the first surface 434.

Referring to FIG. 12, the second interface portion I2 according to an embodiment of the disclosure may extend between the second surface 435 and the first surface 434 of the first portion 433 of the heat dissipation member 1430 and may be disconnected at least once. The second interface portion I2 may extend curvedly between the second surface 435 of the first portion 433 and the first surface 434.

Referring to FIG. 13, according to an embodiment, the third interface portion I3 may be spaced apart from the second surface 435 and the first surface 434 of the first portion 433 of the heat dissipation member 1430 and may extend between the second surface 435 and the first surface 434 of the first portion 433. The third interface portion I3 may extend curvedly between the second surface 435 and the first surface 434 of the first portion 433.

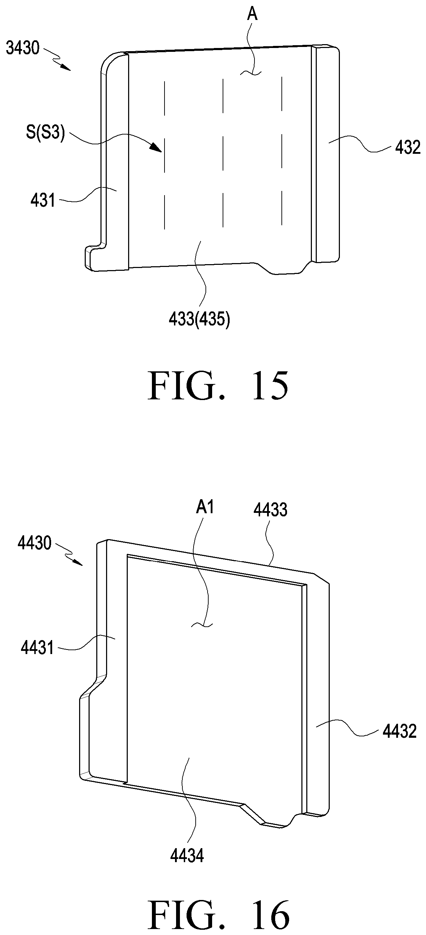

FIG. 14 is a perspective view illustrating a heat dissipation member 2430 having a slot S2 according to an embodiment of the disclosure. FIG. 15 is a perspective view illustrating a heat dissipation member 3430 having a slot S3 according to an embodiment of the disclosure.

The description of the heat dissipation member 430 made with reference to FIGS. 3 to 9 may be equally applied to the heat dissipation members 2430 and 3430 of the same name described with reference to FIGS. 14 and 15 unless contradictory.

The description of the slot S made with reference to FIGS. 10 to 13 may be equally applied to the slots S1 and S2 of the same name described with reference to FIGS. 14 and 15 unless contradictory.

Referring to FIG. 14, the plurality of slots S2 may extend in a direction crossing the length directions of the second portions 431 and 432 of the heat dissipation member 2430. A plurality of slots S2 may extend side by side with each other. Referring to FIG. 15, the plurality of slots S3 may extend along the length directions of the second portions 431 and 432 of the heat dissipation member 2430. A plurality of slots S3 may extend side by side with each other. The extending directions of the slots S2 and S3 may be any one of the extending directions of the first portion 433, and the plurality of slots S2 and S3 may extend in different directions.

FIG. 16 is a perspective view illustrating a heat dissipation member 4430 according to an embodiment of the disclosure.

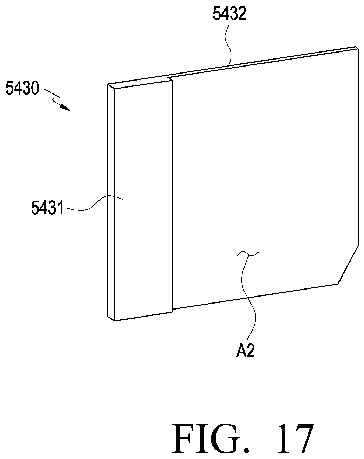

The description of the components (the heat dissipation member 430 and the accommodation area A) made with reference to FIGS. 3 to 9 may be equally applied to the components (the heat dissipation members 4430 and 5430 and the accommodation areas A1 and A2) of the same name described with reference to FIGS. 16 and 17 unless contradictory.

Referring to FIG. 16, the heat dissipation member 4430 according to an embodiment of the disclosure may include a plurality of second portions 4431, 4432, and 4433. The plurality of second portions 4431, 4432, and 4433 may extend along the second surface E22 of the second electronic component E2 (see FIG. 7). A plurality of second portions 4431, 4432, and 4433 may be connected to each other. The first portion 4434 and the plurality of second portions 4431, 4432, and 4433 of the heat dissipation member 4430 may form an accommodation space A1. The second electronic component E2 may be accommodated in the accommodation space A1 of the heat dissipation member 4430.

According to an embodiment of the disclosure, the plurality of second portions 4431, 4432, and 4433 may face the second surface E22 of the second electronic component E2 (see FIG. 7). The plurality of second portions 4431, 4432, and 4433 may contact a first surface (e.g., the first surface E11 of the first electronic component E1 of FIG. 3) of the first electronic component E1.

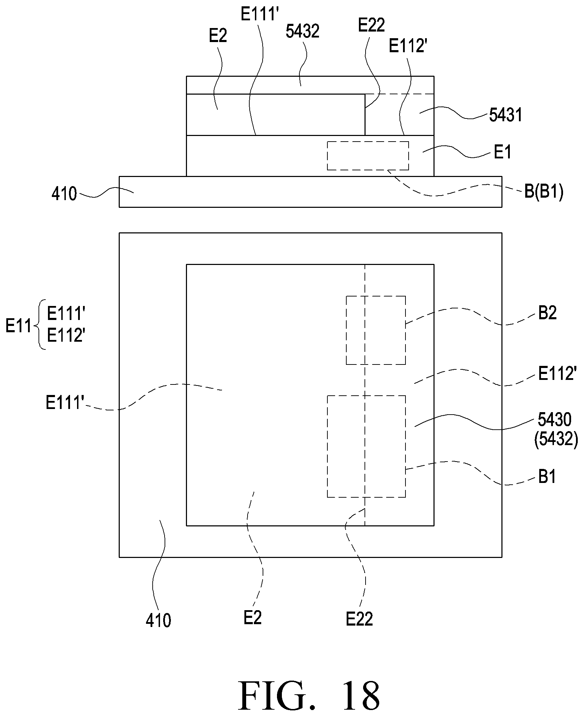

FIG. 17 is a perspective view illustrating a heat dissipation member 5430 according to an embodiment of the disclosure. FIG. 18 illustrates an electronic component E1 or E2 and a heat dissipation member 5430 disposed on the electronic component E1 or E2 as viewed in two directions according to an embodiment of the disclosure.

The description of the components (the heat dissipation member 430, the first portion 433 of the heat dissipation member 430, the second portions 431 and 432 of the heat dissipation member 430, the accommodation area A, the first area E111, and the second area E112) made with reference to FIGS. 3 to 9 may be equally applied to the components (the heat dissipation member 5430, the first portion 5432 of the heat dissipation member 5430, the second portion 5431 of the heat dissipation member 5430, the accommodation area A2, the first area E111', and the second area E112') of the same name described with reference to FIGS. 17 and 18 unless contradictory.

Referring to FIGS. 17 and 18, the first surface E11 of the first electronic component E1 according to an embodiment of the disclosure may include a first area E111' and a second area E112'. The first area E111' may be positioned at an edge of the first surface E11. As an example, the first surface E11 may be bisected by the first area E111' and the second area E112'.

According to an embodiment of the disclosure, the second electronic component E2 may be disposed on the first area E111' of the first surface E11. The second portion 5431 of the heat dissipation member 5430 may contact the second area E112' of the first surface E11.

According to an embodiment of the disclosure, the heat dissipation member 5430 may include a first portion 5432 and a second portion 5431. The first portion 5432 of the heat dissipation member 5430 may be disposed on the second electronic component E2. The first portion 5432 of the heat dissipation member 5430 may contact one surface (e.g., the first surface E21 of the second electronic component E2 of FIG. 3) of the second electronic component E2. The second portion 5431 may protrude from one side of the first portion 5432.

According to an embodiment of the disclosure, the second portion 5431 may protrude from the first portion 5432 toward the second area E112'. The second portion 5431 may extend along the second surface E22 of the second electronic component E2 (see FIG. 7). The second portion 5431 may face the second surface E22 of the second electronic component E2 (see FIG. 7). The second portion 5431 of the heat dissipation member 5430 may be configured to contact the second surface E22 of the second electronic component E2. As an example, when the temperature of the heat dissipation member 5430 rises and exceeds the threshold temperature Tc (see FIG. 5), the heat dissipation member 5430 in the gel phase may tightly contact the side surface E22 of the second electronic component E2.

According to an embodiment of the disclosure, the first portion 5434 and the second portion 5431 of the heat dissipation member 5430 may form an accommodation space A2. The second electronic component E2 may be accommodated in the accommodation space A2 of the heat dissipation member 5430. The second portion 5431 may contact the first surface E11 of the first electronic component E1.

According to an embodiment of the disclosure, the first electronic component E1 may include a hot block B. The hot block B may be positioned below the first surface E11 and may overlap the second area E112. The hot block B may be positioned below a boundary between the first area E111 and the second area E112. Heat generated in the hot block B may be diffused to the second electronic component E2 through the first area E111. Heat generated in the hot block B may be diffused to the second portion 432 of the heat dissipation member 430 through the second area E112.

According to an embodiment of the disclosure, the heating portion B may include a first heating portion B1 and a second heating portion B2. The first heating portion B1 and the second heating portion B2 may be positioned below the first surface E11 and may overlap the second area E112. As an example, the first heating portion B1 may be a CPU of a processor (e.g., the processor 120 of FIG. 1), and the second heating portion B2 may be a GPU of a processor (e.g., the processor 120 of FIG. 1).

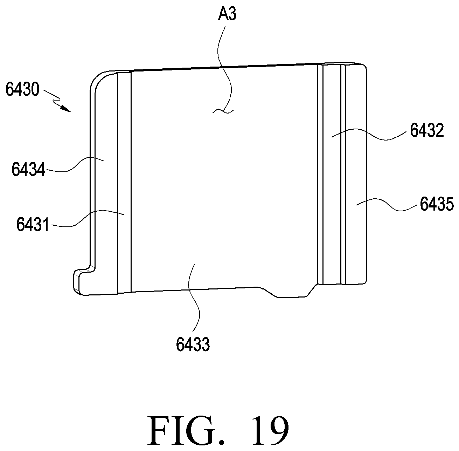

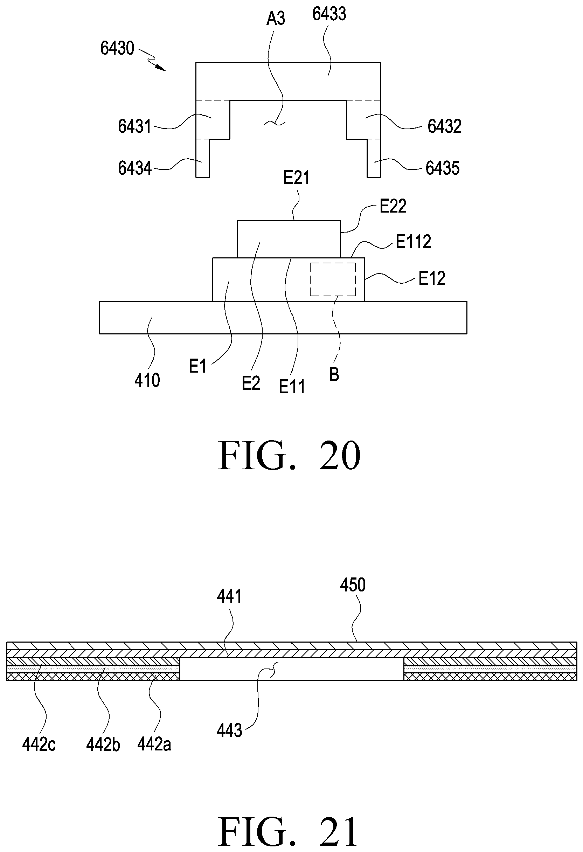

FIG. 19 is a perspective view illustrating a heat dissipation member 6430 according to an embodiment of the disclosure. FIG. 20 is a side view illustrating a heat dissipation member 6430 and electronic components E1 and E2 according to an embodiment of the disclosure.

The description of the components (the heat dissipation member 430, the first portion 433 of the heat dissipation member 430, the second portions 431 and 432 of the heat dissipation member 430, and the accommodation area A) made with reference to FIGS. 3 to 9 may be equally applied to the components (the heat dissipation member 6430, the first portion 6433 of the heat dissipation member 6430, the second portions 6431 and 6432 of the heat dissipation member 6430, and the accommodation area A3) of the same name described with reference to FIGS. 19 and 20.

Referring to FIGS. 19 and 20, the heat dissipation member 6430 according to an embodiment of the disclosure may include third portions 6434 and 6435 extending from the second portions 6431 and 6432 toward the printed circuit board 410. The third portions 6434 and 6435 of the heat dissipation member 6430 may be configured to contact the second surface E12 of the first electronic component E1. The surfaces E11 and E12 of the first electronic component E1 may include a first surface E11 and a second surface E12. As an example, the first surface E11 of the first electronic component E1 may be a top surface, and the second surface E12 of the first electronic component E1 may be a side surface of the first electronic component E1.

According to an embodiment of the disclosure, the second portions 6431 and 6432 of the heat dissipation member 6430 may contact the second area E112 of the first surface E11 of the first electronic component E1. When the temperature of the heat dissipation member 6430 rises to a temperature higher than the phase change temperature Tc (see FIG. 5), the second portions 6431 and 6432 of the heat dissipation member 6430 may be changed into the gel phase to tightly contact the second surface E22 of the second electronic component E2.

According to an embodiment of the disclosure, the heat dissipation member 6430 may include third portions 6434 and 6435 protruding from the second portions 6431 and 6432 toward the printed circuit board 410. The third portions 6434 and 6435 may be configured to contact at least a portion of the second surface E12 of the first electronic component E1. The third portions 6434 and 6435 may face at least a portion of the second surface E12 of the first electronic component E1. When the temperature of the heat dissipation member 6430 rises to a temperature higher than the threshold temperature Tc (see FIG. 5), the third portions 6434 and 6435 of the heat dissipation member 6430 may be changed into the gel phase to tightly contact the second surface E12 of the first electronic component E1. The first portion 6433, the second portions 6431 and 6432, and the third portions 6434 and 6435 of the heat dissipation member 6430 may form an accommodation space A3 in which the first electronic component E1 and the second electronic component E2 are accommodated.

According to an embodiment of the disclosure, widths of the second portions 6431 and 6432 and the widths of the third portions 6434 and 6435 of the heat dissipation member 6430 may be different from each other. As an example, the widths of the third portions 6434 and 6435 may be smaller than the widths of the second portions 6431 and 6432.

FIG. 21 is a cross-sectional view illustrating a conductive layer 440 according to an embodiment of the disclosure.

According to an embodiment of the disclosure, the conductive layer 440 may include a first conductive sheet 441. The first conductive sheet 441 may include a conductive layer 441 disposed on the heat dissipation member 430. As an example, the first conductive sheet 441 may be a copper thin film. The first surface of the first conductive sheet 441 may be disposed on the heat dissipation member 430.

According to an embodiment of the disclosure, the heat dissipation material 450 may be coated on the second surface of the first conductive sheet 441 opposite to the first surface. A heat dissipation material 450 may be coated on the second top surface of the first conductive sheet 441. The coating layer 450 may include a non-conductive heat dissipation material.

According to an embodiment of the disclosure, the heat dissipation material 450 coated on the first top surface of the first conductive sheet 441 may be referred to as the coating layer 450. The heat dissipation material 450 is a material having a low compression rate, and may minimize and/or reduce being dented by a nozzle during a mounting process. The heat dissipation material 450 is a material having a small adhesive strength, and may minimize and/or reduce sticking to the nozzle during a mounting process. As an example, the heat dissipation material 450 may include an electric nonconductor such as aluminum oxide (Al2O3) or aluminum nitride (AlN). As another example, the heat dissipation material 450 may be carbon fiber, graphene, boron nitride (BN), silicon carbide (SiC), magnesium oxide (MgO), or manganese oxide (ZnO).

According to an embodiment of the disclosure, the conductive layer 440 may include a second conductive sheet 442. The second conductive sheet 442 may include a second opening 443. The second conductive sheet 442 may include a plurality of conductive layers 442a, 442b, and 442c. The plurality of conductive layers 442a, 442b, and 442c may include a material having compressibility. As an example, the second conductive sheet 442 may be thicker than the first conductive sheet 441. As an example, the compression rate of the second conductive sheet 442 may be larger than the compression rate of the first conductive sheet 441. As an example, the second conductive sheet 442 including the plurality of conductive layers 442a, 442b, and 442c may have a compression rate larger than or equal to a compression rate (e.g., about 35% or more) of the heat dissipation member 430 in the gel phase. The compressed second conductive sheet 442 may have a higher shielding effect than the second conductive sheet 442 before being compressed.

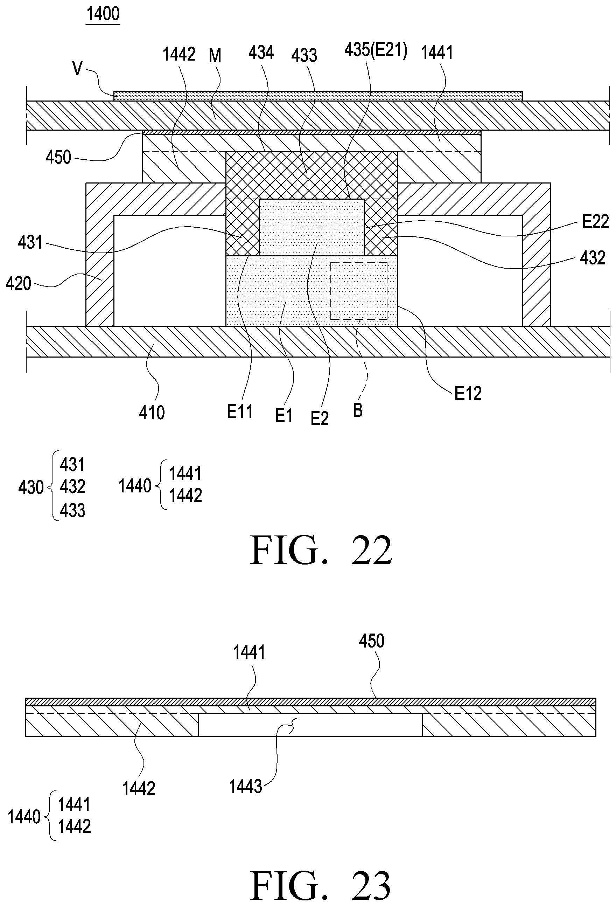

FIG. 22 is a cross-sectional view illustrating a portion of an electronic device (e.g., the electronic device 101 of FIG. 2) according to an embodiment of the disclosure, illustrating a substrate assembly 1400. FIG. 23 is a cross-sectional view illustrating the conductive layer 1440 of FIG. 22 according to an embodiment of the disclosure.

The description of the substrate assembly 400 and the conductive layer 440 made with reference to FIGS. 3 to 9 and 21 may be equally applied to the substrate assembly 1400 and the conductive layer 1440 of the same name described with reference to FIGS. 22 and 23 unless contradictory.

Referring to FIGS. 22 and 23, a substrate assembly 1400 according to an embodiment of the disclosure may include a conductive layer 1440. The conductive layer 1440 may partially cover the heat dissipation member 430. As an example, the conductive layer 1440 may cover a portion of a top surface (e.g., the top surface 434 of the heat dissipation member 430 of FIG. 4) and a side surface (e.g., the side surface 430o of the heat dissipation member 430) of the heat dissipation member 430.

According to an embodiment of the disclosure, the conductive layer 1440 may be disposed between the metal cover M and the shield can 420. The second portion 1442 may be interposed between the first portion 1441 and the shield can 420. The conductive layer 1440 may have compressibility. When the substrate assembly 1400 is assembled, the heat dissipation member 430 in the gel phase and the conductive layer 1440 may be compressed.

According to an embodiment of the disclosure, the conductive layer 1440 may include a first portion 1441 and a second portion 1442. The first portion 1441 and the second portion 1442 of the conductive layer 1440 may contact the heat dissipation member 430. The second portion 1442 of the conductive layer 1440 may at least partially surround a side surface (e.g., the side surface 430o of the heat dissipation member 430 of FIG. 4) of the heat dissipation member 430. As an example, the first portion 1441 may cover at least a portion of a top surface (e.g., the top surface 434 of the heat dissipation member 430 of FIG. 4) and a side surface (e.g., the side surface 430o of the heat dissipation member 430) of the heat dissipation member 430, and may contact the top surface and the side surface of the heat dissipation member 430.According to an embodiment of the disclosure, the conductive layer 1440 may include a recessed space 1443 in which the heat dissipation member 430 is at least partially accommodated. The conductive layer 1440 may include a recess forming the recessed space 1443. The recess of the conductive layer 1440 may face a top surface 434 (see FIG. 4) of the heat dissipation member 430. The second portion 1442 of the conductive layer 1440 may surround the recessed space 1443.

As the degree of integration of electronic components (e.g., a processor, memory, etc.) increases and performance is enhanced, the amount of heat generated by electronic components is increasing. In this case, without decreasing the temperature of the electronic component due to heat generation, the operation of the electronic device may be influenced (e.g., deterioration of performance due to throttling). Accordingly, many studies have been conducted on a heat dissipation structure for electronic components.

An objective of the disclosure may be to provide a heat dissipation structure for electronic components contacting a plurality of outer surfaces of electronic components.

An objective of the disclosure may be to provide a heat dissipation structure for a plurality of electronic components stacked on each other.

An objective of the disclosure may be to increase the contact area between the heat dissipation member and the electronic component.

An objective of the disclosure may be to provide a heat dissipation structure that does not impair shielding performance of a surrounding shielding structure.

An objective of the disclosure may be to provide a heat dissipation member easy to disposed and assemble.

An objective of the disclosure may be to increase the contact area between the heat dissipation member and an electronic component by changing the phase of the heat dissipation member.

Objectives of the disclosure are not limited to those mentioned, but may rather be diverse without departing from the spirit and scope of the disclosure.

In the electronic device according to various embodiments of the disclosure, since the heat dissipation member contacts a plurality of (e.g., two) electronic components stacked on each other, heat of the plurality of electronic components stacked on each other may be effectively discharged.

In the electronic device according to various embodiments of the disclosure, since the heat dissipation member absorbs heat and changes from a solid phase to a gel phase, the contact area between the heat dissipation member and the electronic component may be increased.

In the electronic device according to various embodiments of the disclosure, the heat dissipation member or the material of the heat dissipation member is not introduced into the spaces between the shielding members. Thus, it is possible to provide a heat dissipation structure that does not impair the shielding performance of the ambient shielding structure.

In an electronic device according to various embodiments of the disclosure, since the heat dissipation member is changed from a solid phase in which the heat dissipation member is easy to dispose to a gel phase having a high compression rate, it is possible to provide a heat dissipation member easy to dispose and assemble.

Effects obtainable from the disclosure are not limited to the above-mentioned effects, and other effects not mentioned may be clearly understood by those skilled in the art from the above description.

According to an embodiment of the disclosure, an electronic device 101 may include a first electronic component E1 disposed on a printed circuit board 410.

According to an embodiment of the disclosure, the electronic device 101 may include a second electronic component E2 mounted on a first surface E11 of the first electronic component E1.

According to an embodiment of the disclosure, the second electronic component E2 may be disposed at a first area E111 of the surface E11 or E12 of the first electronic component E1.

According to an embodiment of the disclosure, the electronic device 101 may include a thermoresponsive heat dissipation member 430 comprising a heat dissipation material and contacting the first electronic component E1 and the second electronic component E2.

According to an embodiment of the disclosure, the heat dissipation member 430 may contact the second area E112 of the surface E11 or E12 of the first electronic component E1.

According to an embodiment of the disclosure, the heat dissipation member 430 may contact a top surface of the second electronic component E2.

According to an embodiment of the disclosure, the second electronic component E2 may include a first surface E21 spaced apart from the first surface E11 of the first electronic component E1.

According to an embodiment of the disclosure, the second electronic component E2 may include a second surface E22 extending from the first surface E21 of the second electronic component E2 toward the first surface E11 of the first electronic component E1.

According to an embodiment of the disclosure, the heat dissipation member 430 may include a first portion 433 contacting the first surface (top surface) E21 of the second electronic component E2.

According to an embodiment of the disclosure, the heat dissipation member 430 may include a second portion 431 or 432 extending from the first portion 433 toward the first surface E11 of the first electronic component E1.

According to an embodiment of the disclosure, the second portion 431 or 432 may contact the first surface E11 of the first electronic component E1.

According to an embodiment of the disclosure, the second portion 431 or 432 may face the second surface E22 of the second electronic component E2.

According to an embodiment of the disclosure, the second portion 431 or 432 may contact the second surface E22 of the second electronic component E2.

According to an embodiment of the disclosure, the heat dissipation member 430 may be in a solid phase at room temperature Tr.

According to an embodiment of the disclosure, the heat dissipation member 430 may be configured to be softened based on the temperature of the heat dissipation member 430 is higher than a threshold temperature Tc higher than the room temperature Tr.

According to an embodiment of the disclosure, the heat dissipation member 430 may be configured to have a compression rate of 35% or more based on the temperature is higher than the threshold temperature Tc.

According to an embodiment of the disclosure, based on the temperature of the heat dissipation member 430 is higher than the threshold temperature Tc, the heat dissipation member 430 may be configured to be at least partially changed into a gel phase.

According to an embodiment of the disclosure, the second portion 431 or 432 of the heat dissipation member 430 may be configured to contact the second surface E22 of the second electronic component E2 based on the temperature of the heat dissipation member 430 is higher than the threshold temperature Tc.

According to an embodiment of the disclosure, the heat dissipation member 430 may include a phase change material that is in a solid phase at room temperature Tr.

According to an embodiment of the disclosure, the phase change material may change from a solid phase to a liquid phase or a gel phase at the phase change temperature Tc.

According to an embodiment of the disclosure, the phase change material may include a paraffin based material.

According to an embodiment of the disclosure, the heat dissipation member 430 may include a matrix material configured to maintain the heat dissipation member 430 in a gel phase at a temperature higher than the phase change temperature Tc.

According to an embodiment of the disclosure, the threshold temperature Tc may be lower than a throttling temperature Tt of the first electronic component E1.

According to an embodiment of the disclosure, the first electronic component E1 may include a plurality of processing cores.

According to an embodiment of the disclosure, the threshold temperature Tc may be lower than throttling temperatures of the plurality of processing cores.

According to an embodiment of the disclosure, the first surface E11 of the first electronic component E1 may include a first area E111 at which the second electronic component E2 is disposed.

According to an embodiment of the disclosure, the first surface E11 of the first electronic component E1 may include a second area E112 at least partially surrounding the first area E111.

According to an embodiment of the disclosure, the second area E112 may contact the second portion 431 or 432 of the heat dissipation member 430.

According to an embodiment of the disclosure, the second portion 431 or 432 of the heat dissipation member 430 may protrude from an edge of the first portion 433 of the heat dissipation member 430 toward the second area E112 of the surface E11 or E12 of the first electronic component E1.

According to an embodiment of the disclosure, the heat dissipation member 430 may include at least one interface portion I1, I2, or I3) positioned on the first portion 433 of the heat dissipation member 430 and extending between the first surface 434 and the second surface 435 of the first portion 433.

According to an embodiment of the disclosure, the first portion 433 and the second portion 431 or 432 of the heat dissipation member 430 may be bonded to each other by heat.

According to an embodiment of the disclosure, the second portion 431 or 432 of the heat dissipation member 430 may be non-conductive, and the first portion 433 of the heat dissipation member 430 may be conductive.

According to an embodiment of the disclosure, the surface E11 or E12 of the first electronic component E1 may include a first surface E11 including the first area E111 and the second area E112, and a second surface E12 bent from the first surface.

According to an embodiment of the disclosure, the heat dissipation member 6430 may include a third portion 6434 or 6435 protruding from the second portion 6431 or 6432 toward the printed circuit board 410.

According to an embodiment of the disclosure, the third portion 6434 or 6435 may contact at least a portion of the second surface E12 of the first electronic component E1.

According to an embodiment of the disclosure, the thermal conductivity of the second portion 431 or 432 of the heat dissipation member 430 may be higher than the thermal conductivity of the first portion 433 of the heat dissipation member 430.

According to an embodiment of the disclosure, the electronic device 101 may include a conductive layer 440 or 1440 covering the first opening 421 of the shield can 420 and contacting the first surface 434 and the second surface 430o of the heat dissipation member 430.

According to an embodiment of the disclosure, the electronic device 101 may include a coating layer 450 coated on a second surface opposite to the first surface of the conductive layer 440 or 1440 contacting the heat dissipation member 430 and including a non-conductive heat dissipation material.

According to an embodiment of the disclosure, the conductive layer 440 may include a first conductive sheet 441 contacting the first surface 434 of the heat dissipation member 430.

According to an embodiment of the disclosure, the second conductive sheet 442 may surround the second surface 430o of the heat dissipation member 430 and may contact the second surface 430o of the heat dissipation member 430.

According to an embodiment of the disclosure, the electronic device 101 may include a shield can 420 disposed on the printed circuit board 410.

According to an embodiment of the disclosure, the shield can 420 may surround the first electronic component E1 and the second electronic component E2.

According to an embodiment of the disclosure, the shield can 420 may include a first opening 421 in which the heat dissipation member 430 is accommodated.

According to an embodiment of the disclosure, the electronic device 101 may include a second conductive sheet 442 interposed between the shield can 420 and the first conductive sheet 441.

According to an embodiment of the disclosure, the second conductive sheet 442 may include a second opening 443 in which the heat dissipation member 430 is accommodated.

According to an embodiment of the disclosure, the second conductive sheet 442 may have a lower thermal conductivity than the first conductive sheet 441.

According to an embodiment of the disclosure, an edge of the second opening 443 may contact the heat dissipation member 430.

According to an embodiment of the disclosure, the first electronic component E1 may include at least one processing core B.

According to an embodiment of the disclosure, the second electronic component E2 may be operatively connected to the at least one processing core and may store instructions executed by the at least one processing core.

According to an embodiment of the disclosure, the at least one processing core B may at least partially overlap the second area E112 of the surface E11 or E12 of the first electronic component E1.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device comprising:
a printed circuit board (410);
a first electronic component (E1) mounted on the printed circuit board (410);
a second electronic component (E2) mounted on a first area (E111) of a surface (E11, E12) of the first electronic component (E1); and
a thermoresponsive heat dissipation member (430) comprising a heat dissipation material and contacting a second area (E112) of the surface (E11, E12) of the first electronic component (E1) and a top surface (E21) of the second electronic component (E2),
wherein the heat dissipation member (430) is configured to be in a solid phase and is configured to be softened based on a temperature of the heat dissipation member.

2. The electronic device of claim 1, wherein the heat dissipation member (430) is configured to:
be in the solid phase at room temperature (Tr); and
be softened based on a temperature of the heat dissipation member (430) exceeding a threshold temperature (Tc) higher than the room temperature (Tr).

3. The electronic device of claim 1 or 2,
wherein the heat dissipation member (430) is configured to have a compressibility equal to or greater than 35% based on a temperature of the heat dissipation member (430) exceeding the threshold temperature (Tc).

4. The electronic device of any one of claims 1 to 3,
wherein the heat dissipation member (430) is configured to be at least partially in a gel phase when a temperature of the heat dissipation member (430) exceeds the threshold temperature (Tc).

5. The electronic device of any one of claims 1 to 4,
wherein the heat dissipation member (430) comprises:
a first portion (433) contacting a top surface (E21) of the second electronic component (E2); and
a second portion (431, 432) protruding from the first portion (433) toward the second area (E112) of the surface (E11, E12) of the first electronic component (E1),
wherein, based on the temperature of the heat dissipation member (430) exceeding the threshold temperature (Tc), the second portion (431, 432) of the heat dissipation member (430) is configured to contact a lateral surface (E22) of the second electronic component (E2).

6. The electronic device of any one of claims 1 to 5,
wherein the heat dissipation member (430) comprises:
a paraffin based phase change material configured to be in the solid phase at room temperature (Tr) and configured to be changed from the solid phase to a liquid phase or to a gel phase at a threshold temperature (Tc).

7. The electronic device of any one of claims 1 to 6,
wherein the first electronic component (E1) comprises multiple processing cores, and
wherein a threshold temperature (Tc) is lower than throttling temperatures of the multiple processing cores.

8. The electronic device of any one of claims 1 to 7,
wherein the heat dissipation member (430) comprises at least one interface portion (I1, I2, I3) positioned at the first portion (433) of the heat dissipation member (430), the at least one interface portion (I1, I2, I3) extending between a first surface (434) and a second surface (435) of the first portion (433).

9. The electronic device of any one of claims 1 to 8,
wherein the second portion (431, 432) of the heat dissipation member (430) is non-conductive, and the first portion (433) of the heat dissipation member (430) is conductive.

10. The electronic device of any one of claims 1 to 9,
wherein the surface (E11, E12) of the first electronic component (E1) comprises a top surface (E11) including the first area (E111) and the second area (E112), and a lateral surface (E12), and
wherein the heat dissipation member (6430) further comprises a third portion (6434, 6435) protruding from the second portion (6431, 6432) toward the printed circuit board (410) and contacting at least a portion of the lateral surface (E12) of the first electronic component (E1).

11. The electronic device of any one of claims 1 to 10,
wherein a thermal conductivity of the second portion (431, 432) of the heat dissipation member (430) is greater than a thermal conductivity of the first portion (433) of the heat dissipation member (430).

12. The electronic device of any one of claims 1 to 11, further comprising:
a shield can (420) disposed on the printed circuit board (410) and surrounding the first electronic component (E1) and the second electronic component (E2), the shield can (420) comprising an opening (421) where the heat dissipation member (430) is accommodated; and
a conductive layer (440; 1440) covering the opening (421) of the shield can (420) and contacting a first surface (434) and a second surface (430o) of the heat dissipation member (430).

13. The electronic device of any one of claims 1 to 12,
wherein the conductive layer (440) comprises:
a first conductive sheet (441) contacting the first surface (434) of the heat dissipation member (430); and
a second conductive sheet (442) interposed between the shield can (420) and the first conductive sheet (441) and surrounding the second surface (430o) of the heat dissipation member (430) and contacting the second surface (430o) of the heat dissipation member (430),
wherein a thermal conductivity of the second conductive sheet (442) is lower than a thermal conductivity of the first conductive sheet (441).

14. The electronic device of any one of claims 1 to 13, further comprising:
a coating layer (450) coated on a second surface opposite to a first surface of the conductive layer (440; 1440) which contacts the heat dissipation member (430) and including a non-conductive heat dissipation material.

15. The electronic device of any one of claims 1 to 14,
wherein the first electronic component (E1) comprises at least one processing core, and
wherein the second electronic component (E2) is operably connected to the at least one processing core and stores instructions executable by the at least one processing core,
wherein, when viewed from above the top surface (E21) of the second electronic component (E2), the at least one processing core at least partially overlaps with the second area (E112) of the surface (E11, E12) of the first electronic component (E1).
